# EUROPEAN PATENT APPLICATION

(11) **EP 4 675 252 A1**
(43) Date of publication of application: **07.01.2026**
(21) Application number: 24186788.6
(22) Date of filing: 05.07.2024
(51) Int. Cl.: G01N 1/42, H01J 37/02

(54) **SAMPLE PREPARATION**

(71) Applicant: FEI COMPANY, Hillsboro, OR 97124 (US)
(72) Inventor: Hendriksen, Bas, Eindhoven (NL); de Ruiter, Jolet, Eindhoven (NL)
(74) Representative: Robinson, Louise Frances

(57) **Abstract**

The invention relates to methods for determining a property of a sample before imaging in a charged particle microscope and samples prepared by such methods.

## Description

### Field of the Invention

The invention relates to methods for determining a property of a sample before imaging in a charged particle microscope and samples prepared by such methods.

### Background of the Invention

Biology is the natural science that studies life and living organisms, including their physical structure, chemical processes, molecular interactions, physiological mechanisms, development and evolution.

Cell biology is a branch of biology that studies the structure and function of the cell, the basic unit of life. Cell biology is concerned with the physiological properties, metabolic processes, signalling pathways, life cycle, chemical composition and interactions of the cell with their environment. In cell biology, molecular recognition between macromolecules governs all of the most sophisticated processes in cells. The most common macromolecules comprise biopolymers (nucleic acids, proteins, carbohydrates and lipids) and large non-polymeric molecules (such as lipids and macrocycles).

Many researchers are interested in studying macromolecular complexes in their natural environment at high resolution in order to reveal their structural dynamics and interactions. To this end, charged particle microscopy may be used. Charged particle microscopy is a well-known and increasingly important technique for imaging microscopic objects, particularly in the form of electron microscopy (EM). Historically, the basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as so-called "dual-beam" tools (e.g. a FIB-SEM), which additionally employ a "machining" Focused Ion Beam (FIB), allowing supportive activities such as ion-beam milling or lon-Beam-Induced Deposition (IBID), for example.

Cryo-EM is a method which allows the determination of the structure of proteins by imaging a large number of identical protein particles embedded in an ultrathin layer of vitreous ice, which is supported by a sample carrier, i.e. a TEM holder (i.e. sample grid).

Preparing a Cryo-EM sample, for example, comprises the steps of taking an aqueous sample of a biological material (i.e. the "sample", usually a purified protein complex), applying it to a support structure (holder (i.e. sample grid)), reducing its dimension, for example by means of a filter paper, to a layer that is as thin as possible (-100-800 Å, depending on the size of the biological molecule), and then freezing this layer fast enough to prevent the aqueous liquid from crystallising.

The preparation process of the vitrified samples on a holder (i.e. sample grid) (a vitrified holder (i.e. sample grid)) is still a trial-and-error process. The quality of a vitrified holder (i.e. sample grid) resulting from this process, which includes holder (i.e. sample grid) structure integrity, ice thickness, vitreous vs crystalline ice, particle distribution, is usually being assessed by electron microscopy screening methods, which is not always easily accessible.

In view of this, it is an object of the invention to provide a method for determining a property of a sample that addresses at least some of the above issues.

The listing or discussion of an apparently prior-published document in this specification should not necessarily be taken as an acknowledgement that the document is part of the state of the art or is common general knowledge.

### Summary of the Invention

Thus, the present invention provides a method of determining a property of a sample before imaging in a charged particle microscope, the method comprising:
(i) Providing a sample embedded in a matrix on a sample holder (i.e. sample grid);
(ii) Submerging the sample into a coolant [to provide a vitrified sample]; and
(iii) Removing the [vitrified] sample from the coolant;
Characterised in that during the method:
a. a beam of light is directed towards the sample;
b. the light reflected, transmitted and/or emitted from the sample is detected; and
c. a property of the sample, in particular a property of the matrix in which the sample is provided, is determined using a controller.

The present invention also provides sample for imaging in a charged particle microscope, wherein the sample is obtained using a method as defined herein and a charged particle microscope for examining a sample using the method according to one or more of the previous claims, and comprising:
an optics column, including a charged particle source, a final probe forming lens and a scanner, for focusing a beam of charged particles emitted from said charged particle source onto a sample;
a sample stage positioned downstream of said final probe forming lens and arranged for holding said sample;
a first detector for detecting emissions of a first type originating from said sample in response to the incidence of charged particles emitted from said charged particle source;
a control unit and a processing device connected to said first detector;
wherein said charged particle microscope is arranged for receiving a sample prepared by the method as defined herein.

### Description of the Figures

Fig. 1 - shows an example device for performing steps a., b., and c., in the method of the invention.
Fig. 2 - shows an example of the method of the invention where a., b., and c., are conducted after the sample is removed from a vessel of liquid coolant.
Fig. 3 - shows an example of the method of the invention where a., b., and c., are conducted after the sample is removed from jets of liquid coolant.

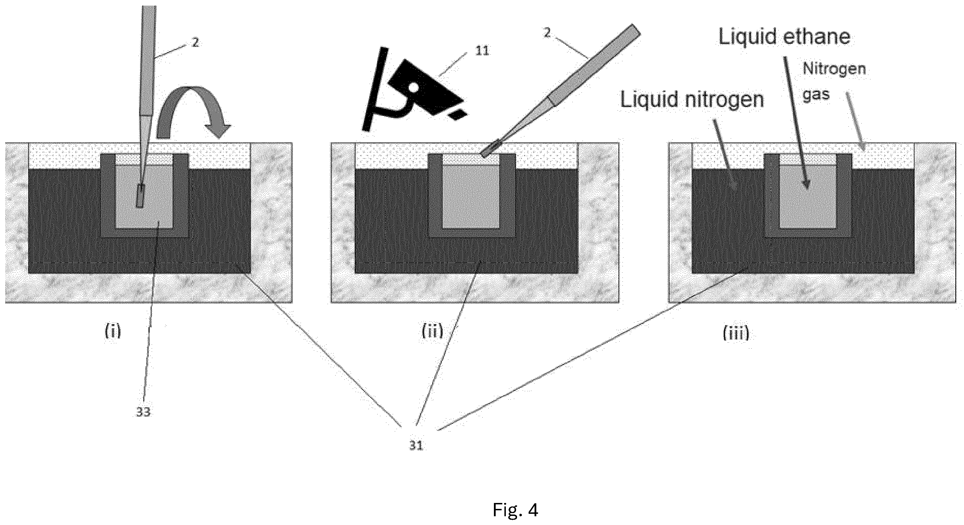

Fig. 4 - shows an example of the method of the invention where a., b., and c., are conducted during the transfer of the sample from the coolant to the additional coolant, (i) showing the sample in the coolant, (ii) showing the sample being transferred from the coolant to the additional coolant, and (iii) showing a possible coolant set up.

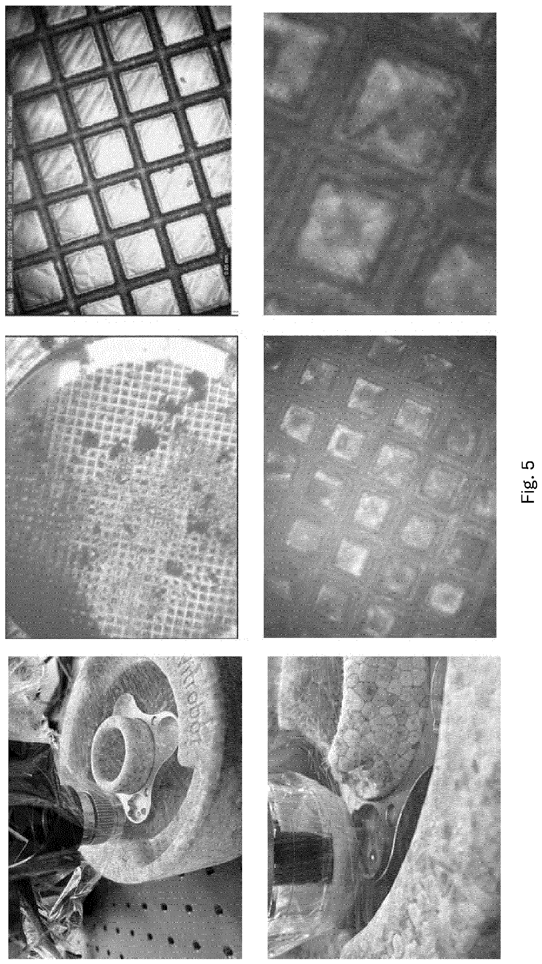

Fig. 5 - shows an example set up of the method of the invention (top and bottom left), and examples of images received after steps a., b., and c., have been conducted.

### Detailed Description of the Invention

In this detailed description of the invention and its various embodiments, for purposes of explanation, numerous specific details are set forth to provide a thorough understanding of the embodiments disclosed. One skilled in the art will appreciate, however, that these various embodiments may be practiced with or without these specific details. Furthermore, one skilled in the art can readily appreciate that the specific sequences in which methods are presented and performed are illustrative and it is contemplated that the sequences can be varied and still remain within the spirit and scope of the various embodiments disclosed herein.

As detailed above, the present invention provides a method of determining a property of a sample before imaging in a charged particle microscope, the method comprising:
(i) Providing a sample embedded in a matrix on a sample holder (i.e. sample grid);
(ii) Submerging the sample into a coolant [to provide a vitrified sample]; and
(iii) Removing the [vitrified] sample from the coolant;
Characterised in that during the method:
a. a beam of light is directed towards the sample;
b. the light reflected, transmitted and/or emitted from the sample is detected; and
c. a property of the sample/matrix is determined using a controller.

In step (i), a sample embedded in a matrix on a sample holder (i.e. sample grid) is provided.

Typically, the matrix is a liquid matrix, for example an aqueous liquid matrix. Alternatively, the matrix may be an aqueous solid matrix, such as an ice layer.

Typically, the sample is a Cryo-EM sample, for example, a biological sample, such as a purified protein complex.

In step (ii), the sample is submerged into a coolant. In this step, the sample is typically transferred to, and then submerged in, the coolant manually, automatically (i.e. using a motorised arm) or a combination thereof, with the sample holder held, for example using tweezers, during the transfer.

As used herein, the term "submerged" is intended to cover situations where the sample is fully covered by the coolant. For example, completely covered in liquid ethane and/or liquid nitrogen. This may be achieved by any suitable means, but it may be preferred that that submersion of done by using a vessel or container of coolant in which the sample can be place into. Alternatively, or additionally, the submersion may be done by completely covering the sample in a jet of coolant.

Submersing the sample in coolant results in vitrification of the sample and the matrix in which the sample is embedded.

It should be noted that where a matrix is referred to this includes where the matrix is in the form of a layer, such as an aqueous layer or an ice layer. It may be preferred that in the method of the invention the matrix is a matrix layer, such as a layer of ice in which the sample is embedded.

The coolant may be any coolant suitable for vitrification of a Cryo-EM sample. For example, the coolant may be liquid ethane or liquid nitrogen or a combination of both.

During submersion, the sample may continue to be held (i.e. by tweezers) in the coolant, or the holding device may be removed, and the sample left in the coolant.

In step (iii), the sample is removed from the coolant. In this step, the sample (now vitrified) may be removed manually or automatically (i.e. using a motorised arm). The sample may be removed using the same holding device (i.e. tweezers) as was used on step (ii) or a further holding device (i.e. tweezers) may be used.

During the method, in order to determine a property of the sample, steps a., b., and c., are conducted.

As used herein, the phrase "determine a property of the sample" is intended to cover a property of the sample as a whole, i.e. including the matrix in which the sample is embedded. Therefore, referring to a property of the matrix, also means a property of the sample and vice versa. The properties of the sample that may be determined as described in more detail below.

In step a., a beam of light from a light source is directed to the sample.

By using a light source and directing it towards the sample directly, and detecting reflected, transmitted and/or emitted light from the sample directly, it is possible to determine a property of the sample, i.e the matrix in a direct way.

As detailed above the matrix may be a liquid, such as a liquid that is used for preparing the sample. The matrix may also be a solid, such as the vitrified liquid that is used for preparing the sample, or any other (semi-)transparent solid, such as a resin, for example.

The light source may be chosen in such a way that it is affected by the sample/matrix. The sample/matrix may, for example, reflect, diffract, transmit, and/or absorb the light from the light source.

By using the detector to detect the reflected, transmitted and/or emitted light, it is possible to distinguish samples based on different properties of said sample/matrix.

The distinguishing, or establishing of said property, may be qualitatively and/or quantitatively.

The light source is typically directed to the sample directly, and the detector is used for measuring light reflected by, transmitted through and/or emitted from, the sample directly.

The light source may comprise at least one optical element, such as a lens.

The optical element may be positioned within a light path between said light source and said detector. The optical element may be arranged for focussing and/or adjusting the beam of light.

The optical element may be arranged for focussing said beam of light onto the sample.

Additionally, or alternatively, the optical element may be arranged for focussing the beam of light onto the detector.

It is conceivable that a plurality of optical elements are provided, each having one or more characteristics as described above.

The at least one optical element may be a colour selective filter. The colour selective filter may be positioned within a light path between said light source and said detector. The colour selective filter may be arranged for passing a restricted band of wavelengths of light towards said detector.

It is noted that the colour selective filter may comprise a plurality of colour selective filter elements, each arranged for passing a different restricted band of wavelengths of light towards said detector.

The plurality of colour selective filter elements may be organized spatially over the detector or may be an integral part of said detector.

As an example, the detector may be selectively sensible for different bands of wavelengths by design, such as for example in the case an RGB pixel camera is used where different pixels are sensitive to different colours.

Additionally, or alternatively, the plurality of colour selective filter elements may be positioned within the light path sequentially, i.e. one after another.

The light source may comprise a laser source. A laser source is relatively cheap.

The laser source may be arranged for projecting a line onto said sample. The line may be scanned across the sample by using relative movement between the laser line and the sample. By using a line source, preferably in combination with a line sensor, it is possible to illuminate a relatively large part of the sample at once, while still retaining spatial information of the sample.

By using a line scan the entire surface of the sample can be screened in a quick and easy way. This helps in establishing spatially resolved data on the property of the sample/matrix. Additional advantage is that this setup does not require the use of relatively expensive 2D sensors.

Alternatively, or additionally, the light source may comprise an LED, arranged for directing a beam of multi-colored or white light towards the sample.

One or more filter elements may be provided. In particular, colour filter elements for a total of three colours may be provided. These colours may be the primary colours red, green and blue, so that the sample can be illuminated with at least three different colours.

When the sample is illuminated with at least three different colours, theory of multi-beam interference from a parallel film may be used for obtaining the thickness of the sample/matrix. This film interference happens because rays reflected at different layers have an interference due to the phase difference. A beam of light hitting a thin film (having a thickness d and a refractive index n) at an angle θ with respect to a normal of said film, has an optical path difference (OPD, or phase shift) that is equal to OPD = 2 n d cos(θ).

Now there are two very distinguishable cases: constructive interference and destructive interference. Destructive interference happens in case the phase difference is 180°, and constructive interference happens in case the phase difference is 0° or 360°. Since the 180° phase difference depends on the wavelength λ, destructive interference as a function of the OPD is then defined as 2 n d cos(θ) = m λi , with m an integer.

By introducing at least three different colours (different wavelengths) a system of equations is obtained, with which the thickness of the thin film can be determined. Similarly, the thickness of a multilayer system (i.e. a grid including a sample/matrix on top) can be determined. It was found that this method is particularly useful for determining the thickness of a vitrified layer. In addition, the use of three colours is advantageous to determine whether contamination occurred in the sample.

Alternatively, or additionally, the light source may also be arranged for producing an ellipsometer beam. In this embodiment the method is arranged for measuring a property of the sample/matrix based on ellipsometry.

With this, the change of polarization upon reflection or transmission of the light source on the sample can be measured and compared to a model.

In view of (vitrified) biological samples, this is in particular useful for measuring the thickness and/or crystalline nature of the sample/matrix. In this embodiment, use may be made of a polarizing element that is provided in between the light source and the sample.

Further, a second polarizing element may be provided in between the sample and the detector. Optionally, one or more compensator elements may be provided in between the light source and the sample, and in between the sample and the detector. A suitable ellipsometry setup is known to those skilled in the art.

Where the light source comprises a 3-color-LED in combination with the above mentioned ellipsometer beam, it is possible to measure sample/matrix thickness (in particular ice thickness) as well as scattering and/or transmission (which is a measure for contamination and/or crystalline nature). The ellipsometry setup may be based on reflection, such that the light source and the detector are arranged on the same side of the specimen. A combined scanning motion is conceivable as well. The spatial resolution may be retrieved by means of deconvolution.

Alternatively, or additionally, the light source may be arranged for producing light in the UV spectrum and/or the IR spectrum.

This embodiment is in particular advantageous for measuring the ice-virtuosity.

In IR and UV the amorphous ice (which normally is considered to be the desired type of ice for biological samples in Cryo-EM) has different optical properties compared to the crystalline ice forms (which normally is considered to be the undesirable type of ice). In particular, the IR absorption coefficient and the refractive index differ between the two types of ice. Further, UV absorption is different for amorphous ice compared to cubic ice. Hence, the use of UV and/or IR light may be advantageously used to determine a property of the sample/matrix, and in the present embodiment a quality of the sample/matrix after vitrification.

In step b., the light reflected, transmitted and/or emitted from the sample is detected.

The detector is typically arranged for receiving reflected, transmitted and/or emitted light from the sample, wherein the normal of said detector is directed in a second direction that is different from said first direction.

In an embodiment, said first direction is non-perpendicular with a normal of said sample.

In an embodiment, said second direction is non-perpendicular to said normal of said sample.

The detector may comprise a plurality of detector units, wherein one of the detector units is arranged for receiving light transmitted through said sample, and another one of the detector units is arranged for receiving light reflected from said sample. This provides additional sample information.

The detector (or plurality of detector units) may comprise a colour camera. The colour camera may be arranged for receiving reflected light, in particular in combination with said LED. This combination is relatively cheap.

It is conceivable, in particular in combination with the laser source, that the detector comprises a CMOS sensor. The CMOS sensor can be a CMOS line-sensor, that can be used with the laser line source mentioned above.

An aforementioned optical element may be used to focus transmitted light from said sample onto the CMOS detector.

In an embodiment, the CMOS line-sensor may comprise a CMOS 16k line-sensor, running at a frame rate that is adapted to the relative movement between the sample and the light source and/or detector. The frame rate may be higher than 250 fps, preferably higher than 500 fps, more preferably higher than 1000 fps. Using this setup, it is possible to obtain a full sample/matrix property map of a 3mm grid within the 15 seconds.

In step c., a property of the sample is determined using a controller.

The controller is typically arranged for evaluating said sample based on the reflected, transmitted and/or emitted light from the sample that is detected.

Utilisation of steps a., b., and c., allows for the acquisition of spatially resolved data, which in turn allows for the determination of a property of the sample.

For example, it is possible to map a 2D (x, y) coordinate system to the sample surface, and to assign a determined property of the sample/matrix to one or more of the coordinates in said 2D coordinate system.

In an embodiment, this may be used for establishing a map of the sample surface with corresponding properties of the sample/matrix. This map provides a valuable insight to the user which sites may be used for further investigation of the sample, and which sites might be best avoided.

It is noted that presently, for Cryo-EM samples, a Cryo-TEM is used in low magnification overview mode to assess the ice quality. This activity blocks the TEM for considerable time. By using the method as disclosed herein, the overview/map/atlas of the grid can be obtained in a rapid and efficient way, and this allows areas that are potentially good for data collection to be identified.

This means that the controller may identify whether parts of the sample are approved or rejected based on the determined property of the sample/matrix. For example, when it is determined that (a part of) the sample/matrix contains a contamination, or that the sample/matrix thickness is not as desired, the controller may indicate that the sample is not suitable for study. The controller may assign an evaluation to a respective 2D coordinate of the sample, or may assign an evaluation for the entire sample.

In a preferred aspect, the controller may be arranged for determining at least one of a measure of thickness of said sample/matrix, a measure of contamination of said sample/matrix, a measure of vitreousness of said sample/matrix.

The property may thus be the thickness and/or measure of contamination of the sample in the method. In case the sample/matrix is vitrified (frozen), then the property may be the vitreousness (or state) of said vitrified sample/matrix.

In a further or alternative aspect, the controller may provide the information on the property of the sample in the form of an image.

The image may provide information on properties of the sample as mentioned above, in particular, information on the thickness, contamination and/or vitreousness of the sample/matrix.

The image may then be reviewed manually or may be input into a computer programme to ascertain to identify whether parts of the sample are approved or rejected based on the determined property of the sample/matrix, i.e. via comparison with images showing the desired properties.

Hence, the present method provides a way for determining a property of the sample via the property of the sample/matrix in a direct way and allows the method to be used at various steps of the method as defined herein.

For example, steps a., b., and c., may be conducted before submersion of the sample in the coolant and/or after removing the sample from the coolant.

As used in the method of the invention, the terms "before submersion" and "after submersion" are intended to cover the time period where the sample is not fully submerged in the coolant. In particular, the time where the sample is held (i.e. with tweezers) above the coolant vessel or container.

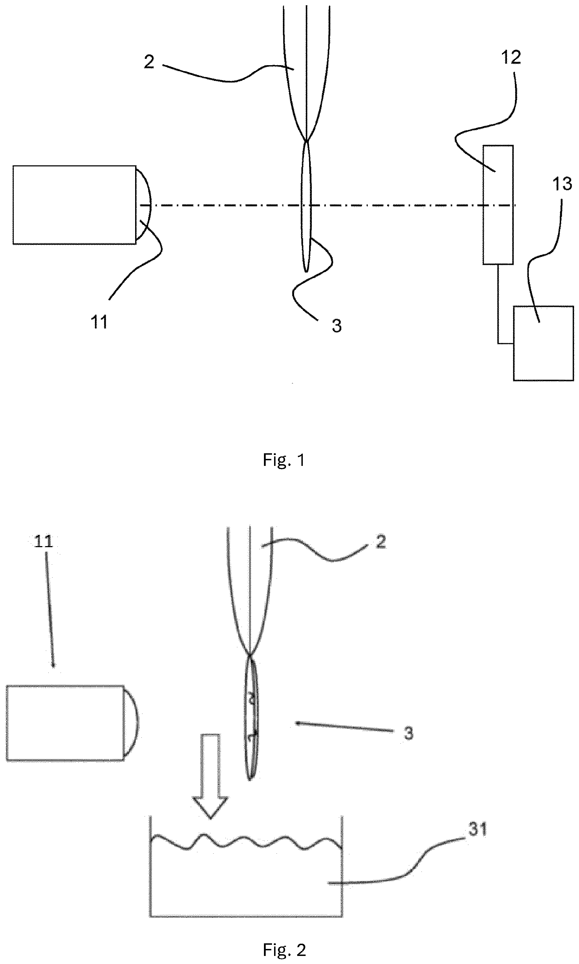

It should be noted that in the method of the invention, the steps a., b., and c., may be performed using a device comprising a light source, a detector and a controller as defined above. An example of such a device is shown in Figure 1.

The device shown in Figure 1 comprises a light source 11 arranged for directing a beam of light towards a sample 3, a detector 12 arranged for detecting light emitted from said sample in response to said beam of light being incident on said sample 3; and a controller 13 connected to said detector 12 and arranged for determining a property of said sample/matrix 7 based on signals received by said detector 12. In the embodiment shown, light emitted by said light source 11 is directed towards the sample 3, and the detector 12 is arranged on the opposite side of the sample 3. In other words, the device is arranged in such a way that the sample can be located in between the light source 11 and the detector 12. Light falling on the sample 3 is scattered and/or absorbed, for example, and the detector 12 detects a certain amount of light depending on the amount of scattering and/or absorption. Thus, the detector 12 is arranged to receive light transmitted through the sample 3. With this it is possible to determine a property of the sample/matrix of the sample 3, such as, for example, the presence of the sample/matrix and/or a sample/matrix thickness.

In a preferred aspect, the method of the invention may further comprise step (iv) where the sample is submerged in an additional coolant, wherein the additional coolant may be the same or different from the initial coolant.

Where the method of the invention comprises this additional step (step (iv)), the method typically includes transferring the removed sample from step (iii) through a gaseous atmosphere before submersion in the additional coolant in step (iv).

The transfer may be performed manually or automatically, or a combination thereof. During the transfer, the sample holder may be held, for example using tweezers, during the transfer.

Where the method of the invention comprises step (iv), steps a., b., and c., may be conducted before submersion of the sample in the additional coolant and/or during transfer of the sample and/or after submersion of the sample in the additional coolant.

In the method of the invention, where step (iv) is present "before" and "after" submersion are as previously defined.

As used in the method of the invention, "during transfer" is intended to mean the period where the sample is being moved from the coolant to the additional coolant.

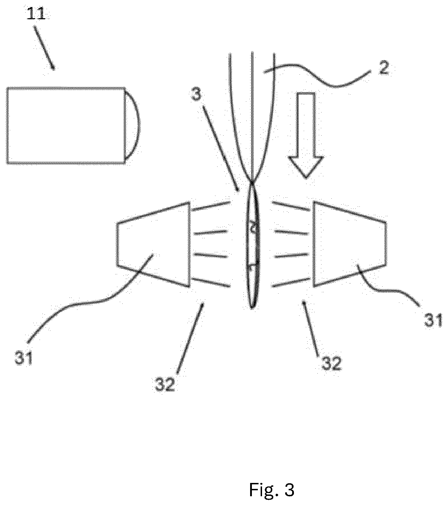

Examples of how the method of the invention where a., b., and c., may be conducted after removing the sample from the coolant are shown in Figures 2 and 3.

In Figures 2 and 3, the light source 11 is shown (without the detector and controller for ease). The light source 11 is positioned slightly above a liquid nitrogen bath 31. The sample 3 may be vitrified in this bath 31, and once removed from the bath, the light source can direct a beam of light towards the sample in order to perform the method of the invention as defined herein and used to check the quality of the obtained sample 3. For example, ice thickness, contamination, and/or crystalline nature of the vitrified sample/matrix may be investigated. In Figure 3, the light source 11 is used in a similar way, with the difference that two opposing ethane jets are used in the vitrifying process.

In the method of the invention, it may be desirable to transfer the sample to a vacuum chamber in order to perform steps a., b., and c.

The transfer to the vacuum chamber may be performed manually or automatically, or a combination thereof. During the transfer, the sample holder may be held, for example using tweezers, during the transfer.

Transfer of the sample to the vacuum chamber may be performed after removing the sample from the coolant in step (i) and/or removing the sample from the coolant in step (iv).

Typically, the method of the invention is conducted externally from the charged particle microscope, such as a (cryo) TEM or SEM. For example, the method may be conducted in a device or area that is not directly connected to the charged particle microscope.

Alternatively, or additionally, the method of the invention may be conducted in a device or area that is indirectly connected to the charged particle microscope. For example, where steps a., b., and c., are conducted in a vacuum chamber, the vacuum chamber may be indirectly connected to the charged particle microscope through a lock or seal, such as in the autoloader system described in EP2722867.

The provision of the method defined herein means that the present invention also provides a sample for use imaging in a charged particle microscope, wherein the sample is obtained using a method as defined in this application.

The invention also provides a charged particle microscope for examining a sample using the method according to one or more of the previous claims, and comprising:
an optics column, including a charged particle source, a final probe forming lens and a scanner, for focusing a beam of charged particles emitted from said charged particle source onto a sample;
a sample stage positioned downstream of said final probe forming lens and arranged for holding said sample;
a first detector for detecting emissions of a first type originating from said sample in response to the incidence of charged particles emitted from said charged particle source;
a control unit and a processing device connected to said first detector;
wherein said charged particle microscope is arranged for receiving a sample prepared by the method as defined in this application.

The descriptions of specific exemplary embodiments of the present invention have been presented for purposes of illustration and description. They are not intended to be exhaustive or to limit the invention to the precise forms disclosed, and obviously many modifications and variations are possible in light of the above teachings. The exemplary embodiments were chosen and described in order to explain certain principles of the invention and their practical application, to thereby enable others skilled in the art to make and utilize various exemplary embodiments of the present invention, as well as various alternatives and modifications thereof. It is intended that the scope of the invention be defined by the Claims appended hereto and their equivalents.

For the avoidance of doubt, in this specification when we use the term "comprising" or "comprises" we mean that the detection cell or system being described must contain the listed components but may optionally contain additional components. Comprising should be considered to include the terms "consisting of' or "consists of" where the flow-through cell or system being described must contain the listed component(s) only.

For the avoidance of doubt, preferences, options, particular features and the like indicated for a given aspect, feature or parameter of the invention should, unless the context indicates otherwise, be regarded as having been disclosed in combination with any and all other preferences, options particular features and the like as indicated for the same or other aspects, features and parameters of the invention.

The term "about" as used herein, e.g. when referring to a measurable value (such as an amount or parameter), refers to variations of ±20%, ±10%, ±5%, ±1%, ±0.5%, or, particularly, ±0.1% of the specified amount.

## Claims

1. A method of determining a property of a sample before imaging in a charged particle microscope, the method comprising:
(i) Providing a sample embedded in a matrix on a sample holder (i.e. sample grid);
(ii) Submerging the sample into a coolant [to provide a vitrified sample]; and
(iii) Removing the [vitrified] sample from the coolant;
**Characterised in that** during the method:
a. a beam of light is directed towards the sample;
b. the light reflected, transmitted and/or emitted from the sample is detected; and
c. a property of the sample is determined using a controller.

2. The method of claim 1, wherein the matrix is an aqueous matrix.

3. The method of any of the preceding claims, wherein the coolant is liquid ethane or liquid nitrogen.

4. The method of any of the preceding claims, wherein steps a., b., and c., are conducted before submersion of the sample in the coolant.

5. The method of any of the preceding claims, wherein steps a., b., and c., are conducted after removing the sample from the coolant.

6. The method of any of the preceding claims, wherein the method further comprises:
(iv) submersion of the sample in an additional coolant, wherein the coolant may be the same or different from the initial coolant.

7. The method of claim 6, wherein the method further comprises transferring the removed sample from step (iii) through a gaseous atmosphere before submersion in an additional coolant in step (iv).

8. The method of claim 6 or 7, wherein steps a., b., and c., are conducted before submersion of the sample in the additional coolant.

9. The method of any of claims 6 to 8, wherein steps a., b., and c., are conducted after submersion of the sample in the additional coolant.

10. The method of any of claims 7 to 9, wherein steps a., b., and c., are conducted during transfer of the sample.

11. The method of any of the preceding claims, wherein the method further comprises the step of transferring the sample to vacuum chamber.

12. The method of claim 11, wherein the step of transferring the sample to the vacuum chamber is conducted after removing the sample from the coolant in step (i) and/or removing the sample from the coolant in step (iv).

13. The method of claim 12, wherein steps a., b., and c., are conducted in the vacuum chamber.

14. A sample for imaging in a charged particle microscope, wherein the sample is obtained using a method as defined in any of claims 1 to 13.

15. A charged particle microscope for examining a sample using the method according to one or more of the previous claims, and comprising:
an optics column, including a charged particle source, a final probe forming lens and a scanner, for focusing a beam of charged particles emitted from said charged particle source onto a sample;
a sample stage positioned downstream of said final probe forming lens and arranged for holding said sample;
a first detector for detecting emissions of a first type originating from said sample in response to the incidence of charged particles emitted from said charged particle source;
a control unit and a processing device connected to said first detector;
wherein said charged particle microscope is arranged for receiving a sample prepared by the method according to any of claims 1 to 13.
